# EUROPÄISCHE PATENTSCHRIFT

(11) **EP 1 973 154 B1**
(45) Veröffentlichungstag und Bekanntmachung des Hinweises auf die Patenterteilung: **25.04.2012**
(21) Anmeldenummer: 07104010.9
(22) Anmeldetag: 13.03.2007
(51) Int. Cl.: H01L 21/677, C23C 14/56, B65G 49/00

(54) **Vorrichtung zum Bewegen eines Carriers in einer Vakuumkammer**
Device for moving a carrier in a vacuum chamber
Dispositif destiné au déplacement d'un vecteur dans une chambre à vide

(43) Veröffentlichungstag der Anmeldung: 24.09.2008
(73) Patentinhaber: Applied Materials, Inc., Santa Clara, CA 95054 (US)
(72) Erfinder: Haberkorn, Edgar, 63637 Jossgrund (DE); Schläfer, Susanne, 63654 Büdingen (DE)
(74) Vertreter: Zimmermann & Partner

(56) Entgegenhaltungen:
- EP-A- 1 648 079
- EP-A1- 0 254 145
- EP-A1- 1 953 259
- JP-A- 2002 110 763
- US-A1- 2002 060 134
- US-B1- 6 251 551

## Beschreibung

Die Erfindung betrifft eine Vorrichtung zum Bewegen eines Carriers in einer Vakuumkammer.

Bei Vakuumbeschichtungsanlagen, die nach dem PECVD-Prinzip (PECVD = Plasma Enhanced Chemical Vapor Deposition) arbeiten, erfolgt die Beschichtung direkt über das in die Anlage eingelassene, durch eine Quelle ionisierte Gas. Ein Plasma brennt zwischen der Quelle und einem Substrat bzw. einer hinter dem Substrat angeordneten Rückelektrode.

Die Substrate werden oft an einem Träger oder Carrier befestigt, der auf Rollen durch die Vakuumbeschichtungsanlage bewegt wird. Diese Rollen werden von Antrieben bewegt, die sich vorzugsweise außerhalb der Vakuumbeschichtungsanlage befinden, damit keine Verunreinigungen in der Beschichtungsanlage auftreten.

Es ist bereits eine Antriebsvorrichtung für eine in einer Kammer befindliche Welle bekannt (US 2005/0206260 A1). Diese Welle wird dabei über eine Magnetkupplung mittels eines Motors angetrieben, der sich außerhalb der Kammer befindet.

Außerdem ist eine Transportvorrichtung für Substrate in Vakuumbeschichtungsanlagen mit mehreren Transportrollen bekannt (DE 103 28 273 A1). Bei dieser Vorrichtung befinden sich sowohl der Antrieb als auch die Transportrollen im evakuierten Bereich der Beschichtungsanlage.

Weiterhin ist eine Prozesskammer bekannt, die ein Transportsystem für Werkstücke aufweist (GB 2 171 119 A). Dieses Transportsystem enthält Walzen, die durch eine Magnetkupplung angetrieben werden. Hierbei dient die Magnetkupplung zum Umschalten zwischen zwei auf einem Lift angebrachten Sätzen von Transportrollen innerhalb der Kammer.

Es ist ferner eine Vorrichtung zur Bewegung von Einbauteilen in Vakuumanlagen bekannt, die ein Verbindungselement innerhalb eines Raums aufweist, das teilweise aus einem magnetischen Material besteht, wobei außerhalb des Raums ebenfalls ein magnetisches Materials angeordnet ist, welches ausschließlich über Kraftschluss mit dem inneren magnetischen Material in Kontakt steht (DE 102 27 365 = EP 1 387 473 A2).

Bei einem bekannten Verfahren zum Behandeln von flächigen Substraten, wie SiliziumScheiben, zur Herstellung mikroelektrischer Bauelemente in vertikaler Ausrichtung sind Antriebsrollen vorgesehen, die an drei Stellen einer kreisrunden Silizium-Scheibe angedrückt werden (US 6 251551 B1). Diese Silizium-Scheibe kann mittels der Antriebsrollen um ihre Achse gedreht werden. Die lineare Weiterbewegung der SiliziumScheiben erfolgt indessen mit Hilfe eines Förderbands.

Zum Rotations-Bewegen eines plattenförmigen und kreisförmigen Carriers ist es bekannt, mehrere Rollen vorzusehen, die am Rand des Carriers angreifen (JP 2002 110763 A). Die Linearbewegung des Carriers erfolgt hierbei jedoch über Schienen.

Eine magnetische Carrier-Vorrichtung mit einer spiral-magnetischen Kupplung ist aus der US 2002/0060134 A1 bekannt. Bei dieser Vorrichtung ist jedoch kein Hubmechanismus für Rollen vorgesehen.

In EP 1648 079 A2 ist ein System zum Übertragen von Bewegung zwischen Gegenständen, die durch eine Wand getrennt sind, beschrieben. Dieses System ist nicht für den Transport von Carriers geeignet.

Schließlich ist auch eine Vakuumbeschichtungsanlage mit Transportrollen für den Transport eines flächigen Substrats bekannt, die einen außerhalb der Vakuumbeschichtungsanlage angeordneten Antrieb und wenigstens eine Magnetkupplung zwischen dem Antrieb und wenigstens einer Transportrolle aufweist (nicht vorveröffentlichte europäische Patentanmeldung EP 1 870 487).

EP 1 953 259 A (ein Dokument gemäß Art. 54 (3) EPÜ) beschreibt unter anderem eine Vorrichtung zum Bewegen eines Carriers in einer Prozesskammer, wobei dieser Carrier mittels Antriebsroller bewegbar ist und wobei die Antriebsrollen mittels einer Hebevorrichtung auf eine Schmalseite des Carriers hin und von diesem weg bewegbar sind. Die Antriebsrollen sind mit einer Magnetkapplung gekoppelt, deren Antrieb außerhalb der Prozesskammer angeordnet ist.

Der Erfindung liegt die Aufgabe zugrunde, innerhalb einer Kammer automatisch Gegenstände wenigstens in eine Richtung zu bewegen.

Diese Aufgabe wird gemäß den Merkmalen des Patentanspruchs 1 gelöst.

Die Erfindung betrifft somit eine Vorrichtung zum Bewegen eines Carriers innerhalb einer Vakuumkammer. Dieser Carrier ist plattenförmig ausgebildet und steht mit seiner schmalseitigen Unterkante auf Rollen, die durch einen Antrieb angetrieben werden. Als Antrieb wird eine Magnetkupplung benutzt, die teilweise innerhalb der Vakuumkammer und teilweise außerhalb der Vakuumkammer angeordnet ist, wobei der außerhalb der Vakuumkammer liegende Teil der Magnetkupplung von einem Motor angetrieben wird. Mit Hilfe einer in vertikaler Richtung wirkenden Kraft können die beiden Teile der Magnetkupplung relativ zueinander verschoben werden. Darüber hinaus ist auch eine horizontale Verschiebung des Carriers möglich.

Ein mit der Erfindung erzielter Vorteil besteht darin, dass Carrier innerhalb einer Vakuumbeschichtungsanlage von Antriebsrollen, welche die Carrier tragen, getrennt werden können. Ein weiterer Vorteil der Erfindung besteht darin, dass die Carrier auch seitlich verschiebbar sind.

Ein Ausführungsbeispiel der Erfindung ist in den Zeichnungen dargestellt und wird im Folgenden näher beschrieben. Es zeigen:
- Fig. 1: eine Gesamtansicht einer Prozesskammer;
- Fig. 2: einen Längsschnitt A-A durch die Prozesskammer der Fig. 1;
- Fig. 3: eine vergrößerte Teildarstellung aus Fig. 2 in einer ersten Position;
- Fig. 4: eine vergrößerte Teildarstellung aus Fig. 2 in einer zweiten Position;
- Fig. 5: einen Teil eines Längsschnitts B-B durch die Prozesskammer der Fig. 1.

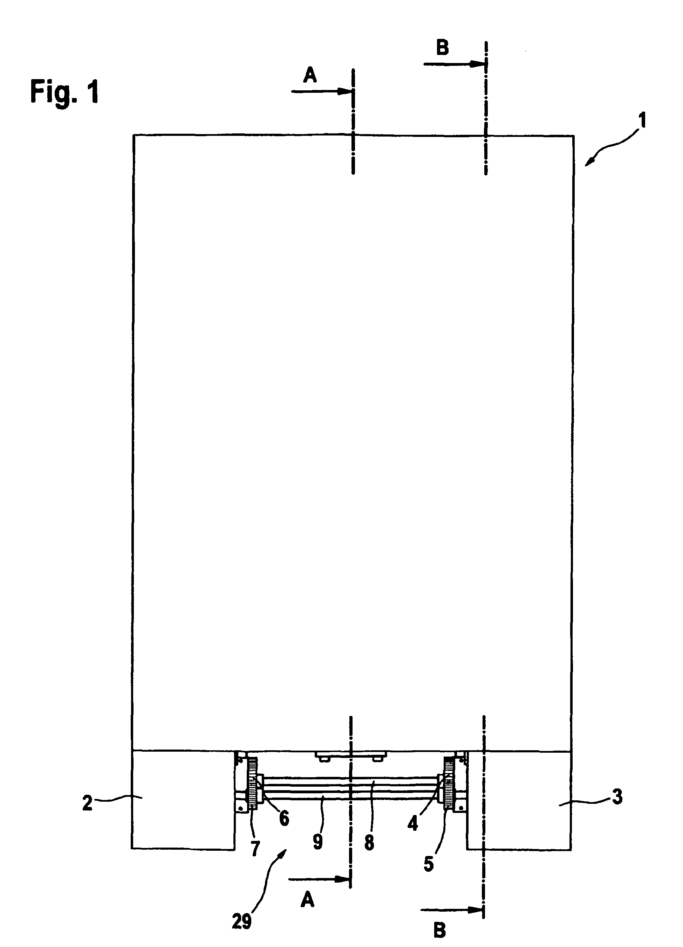

In der Fig. 1 ist eine Prozesskammer 1 in einer Seitenansicht gezeigt. Neben dieser Prozesskammer 1 können sich weitere, nicht dargestellte Kammern befinden. Dabei können diese Kammern Prozess- und/oder Pufferkammern sein.

Die Prozesskammer 1 ruht auf Sockeln 2, 3, zwischen denen sich ein Getriebe 29 mit Zahnrädern 4, 5; 6, 7 und Ausgleichswellen 8, 9 befindet.

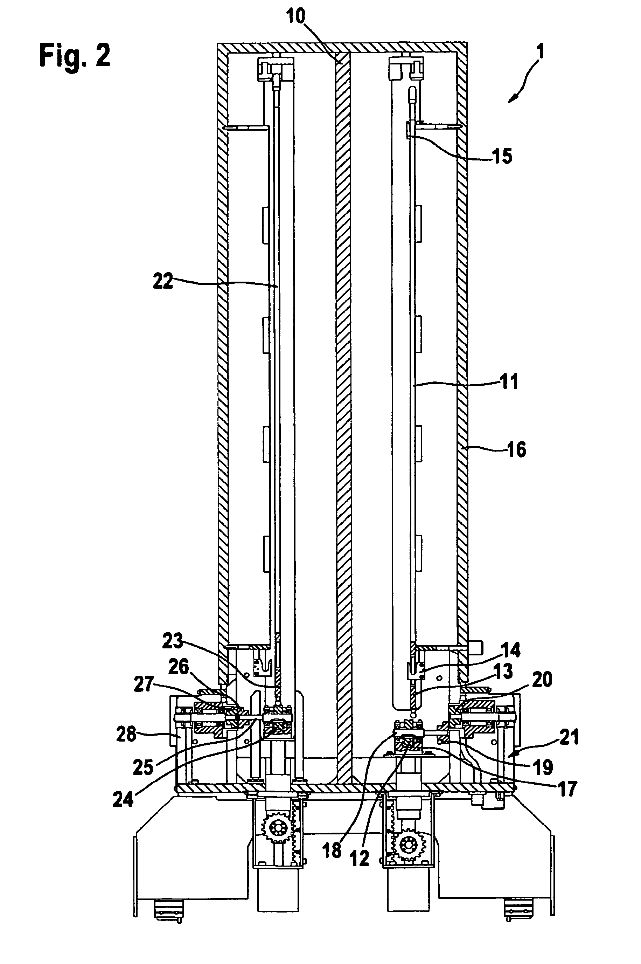

In der Fig. 2 ist ein Schnitt A-A durch die Prozesskammer 1 gezeigt. Man erkennt hierbei, dass die Prozesskammer 1 durch eine Zwischenwand 10 in zwei Hälften unterteilt ist. In der einen Hälfte befindet sich ein Carrier 11, der in die Zeichenebene hineinfahren kann, und zwar auf Führungsrollen, von denen in der Fig. 2 nur zwei Führungsrollen 12, 24 dargestellt sind. Das untere Ende 13 des Carriers 11 ist bei der Darstellung der Fig. 2 gerade von der Rolle 12 entkoppelt und mittels Gabeln 14, 15 und eines nicht dargestellten Antriebs in Richtung auf eine Wand 16 bewegt. Hinter den Sockeln 2, 3 befinden sich Hubkolben, auf die später noch eingegangen wird, die aber in Fig. 1 nicht zu erkennen sind. Ein Getriebe 29 ist nur bei Einsatz von zwei Hubzylindern nötig, um den Hub zu vergleichmäßigen. Mit 17 ist ein Transportbalken bezeichnet, der eine Welle 18 trägt, die durch die Führungsrolle 12 verläuft und mit einer Hälfte 19 einer Magnetkupplung verbunden ist, die sich in der Prozesskammer 1 befindet, und mit einer zweiten Hälfte 20 dieser Magnetkupplung, die außerhalb der Prozesskammer 1 vorgesehen ist, gegenüber liegt. Der Antrieb dieser zweiten Hälfte 20 erfolgt über einen Riemenantrieb 21. Die einander gegenüber liegenden Hälften 19, 20 der Magnetkupplung weisen vorzugsweise glatte Flächen auf, die an einander vorbeigleiten können.

In der durch die Zwischenwand 10 abgetrennten linken Hälfte der Prozesskammer 1 ist ein weiterer Carrier 22 dargestellt, dessen Bewegung derart ist, dass er aus der Zeichenebene heraustritt. Das Ende 23 dieses Carriers 22 ruht in einer Führungsrolle 24, durch die eine Welle 25 führt, welche ihrerseits durch den in der Prozesskammer 1 befindlichen Teil 26 einer Magnetkupplung führt, deren außerhalb der Prozesskammer 1 liegender Teil 27 von einem Riemenantrieb 28 angetrieben wird.

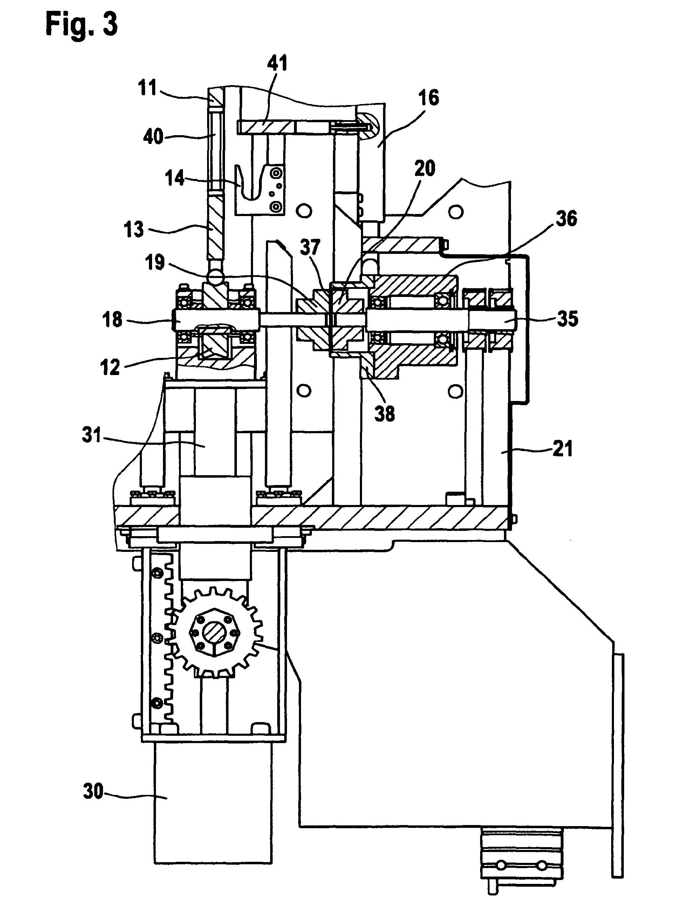

Fig. 3 zeigt eine vergrößerte Darstellung eines Teilsbereichs der Fig. 2. Man erkennt hierbei wieder den Carrier 11 mit seinem unteren Ende 13, das nun in der Führungsrolle 12 ruht. Damit das untere Ende 13 aus der Rolle 12 herausgeführt werden kann, ist ein Pneumatikzylinder 30 vorgesehen, der einen Hubkolben 31 nach oben und nach unten bewegen kann. In der in der Fig. 3 gezeigten Position ist der Hubkolben 31 nach oben gefahren, wodurch auch der Transportbalken 17, die Führungsrolle 12 und mit dieser die Welle 18 und der innere Teil 19 der Magnetkupplung nach oben gefahren werden. Der Teil 19 der Magnetkupplung liegt nun direkt dem äußeren Teil 20 der Magnetkupplung gegenüber. Eine Antriebswelle 35, die in einem Lager 36 ruht und den äußeren Magneten 20 trägt und die von dem Riemenantrieb 21 angetrieben wird, ist ortsfest mit der Wand 16 verbunden. Mit 37 ist eine dünne Membran bezeichnet, welche das Innere der Prozesskammer 1 von Atmosphäre trennt. Diese Membran 37 ist in eine Buchse 38 eingepasst bzw. Teil dieser Buchse 38.

Die Gabel 14 befindet sich bei der in der Fig. 3 dargestellten Position, in welcher der Carrier 11 in die Prozesskammer 1 eingefahren wird, außerhalb des Carriers 11, d. h. sie greift nicht in eine Aussparung 40 dieses Carriers ein, um ihn in Richtung auf die Seitenwand 16 der Prozesskammer 1 zu bewegen. Die Gabel 14 ist nicht an einem Kontaktrahmen 41 befestigt, sondern an einer Durchführung, die eine horizontale Bewegung ausführt. Diese Durchführung ist in der Fig. 3 nicht zu erkennen.

Wird die Antriebswelle 35 durch den Riemenantrieb 21 gedreht, so dreht sich auch der in Atmosphäre befindliche Teil 20 der Magnetkupplung. Sein Magnetfeld tritt durch die nicht magnetische bzw. magnetisierbare Membran 37, die in der Buchse 38 gelagert oder Teil dieser Buchse 38 ist, und nimmt den in der Prozesskammer 1 befindlichen Teil 19 der Magnetkupplung mit. Hierdurch dreht sich die Welle 18 und mit ihr die Führungsrolle 12. Da in dieser Führungsrolle 12 das untere Ende des Carriers 11 gelagert ist, bewegt sich der Carrier 11 in die Zeichenebene hinein.

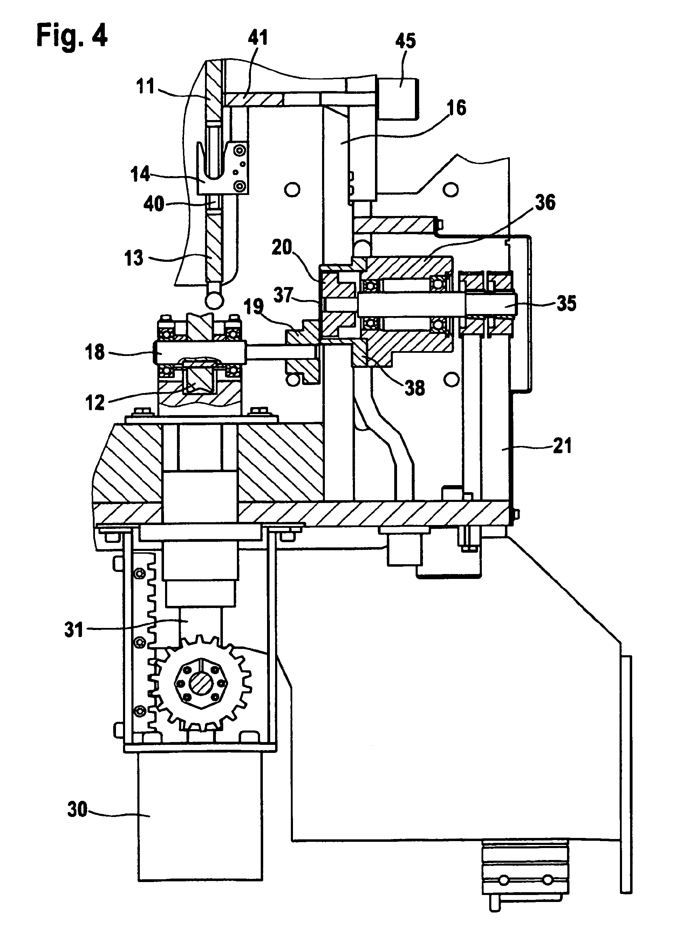

In der Fig. 4 ist noch einmal eine vergrößerte Darstellung eines Teils der in der Fig. 2 gezeigten Vorrichtung dargestellt, und zwar in der Position der Fig. 2, in welcher der Carrier 11 nicht in die Zeichenebene hineinbewegt wird, sondern in Richtung auf die Wand 16 der Prozesskammer 1. Um in diese Position zu gelangen, fährt die Gabel 14, die durch einen Antrieb 45 horizontal nach links bewegt wird, in eine Aussparung 40 im Carrier 11 ein. Jetzt wird der Hubzylinder abgesenkt, sodass der Carrier 11 in der Gabel 14 hängt. Nun kann der Carrier 11 mittels Gabel 14, eines nicht dargestellten Trägers und des Antriebs 45 horizontal bewegt werden. Die beiden Teile 19, 20 der Magnetkupplung sind dabei vertikal zueinander versetzt. Mit 41 ist ein Kontaktrahmen bezeichnet.

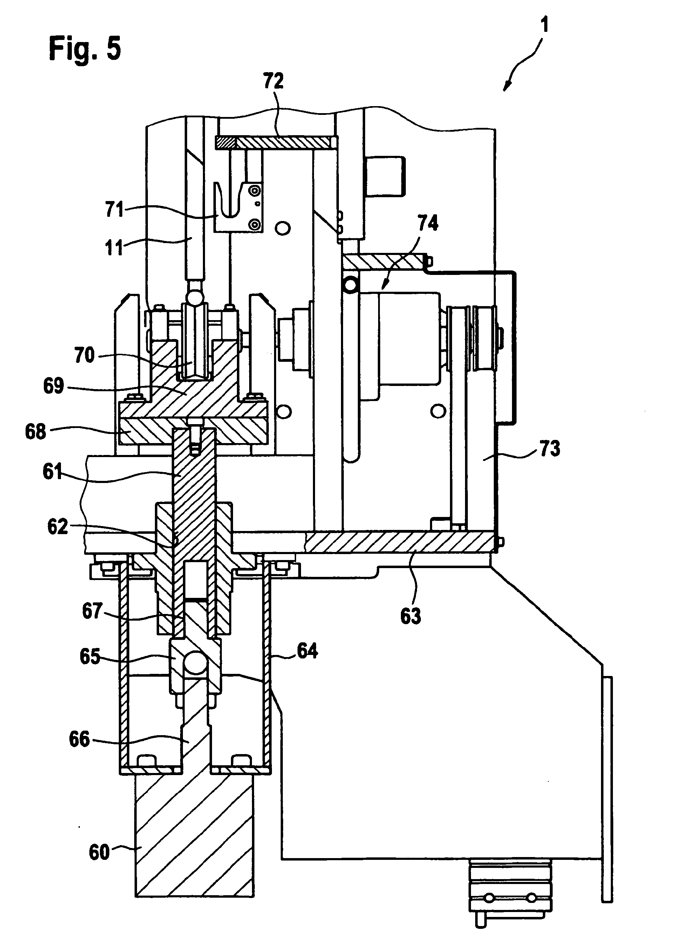

In der Fig. 5 ist ein Ausschnitt aus einem Längsschnitt B-B gezeigt, wobei nur der rechte Carrier 11 zu erkennen ist. Der Längsschnitt der Fig. 5 geht durch einen Hubzylinder 60 und einen mit diesem verbundenen Hubkolben 61. Mit 62 ist eine Durchführung durch den Boden 63 der Prozesskammer 1 bezeichnet. An dem Boden 63 ist ein Halter 64 angeflanscht, in dem sich ein Koppelteil 65 befindet, das eine Kolbenstange 66 des Hubzylinders 60 mit einem Teil 67 des Hubkolbens 61 zeigt. Der Hubzylinder 60 ist ein Pneumatikzylinder, der mit dem Koppelteil 65 in den Kolben 61 geschraubt ist.

Der Hubkolben 61 ist über einen Träger 68 mit einem Transportbalken 69 verbunden, in dem eine Führungsrolle 70 rollen kann. In einem Abstand vom Carrier 11 erkennt man eine Gabel 71, die an einem nicht dargestellten Träger befestigt ist, der mit einem auf der Außenseite der Wand 16 befindlichen und hier nicht dargestellten Antrieb verbunden ist. Ein Riemenantrieb 73 treibt eine Magnetkupplung 74 an, die ihrerseits die Führungsrolle 70 dreht.

Es können zwei Hubkolben pro Transportbalken 69 vorgesehen werden, einer am vorderen und einer am hinteren Ende des Transportbalkens. Möglich ist jedoch auch, dass nur ein Hubkolben vorgesehen ist, der in der Mitte des Transportbalkens 69 angreift. Mit 72 ist ein Kontaktrahmen bezeichnet, aus dem der Carrier 11 gedrückt ist, um einen definierten parallelen Abstand zwischen Plasmaquelle und Substrat zu gewährleisten. Außerdem dient der Kontaktrahmen zur Begrenzung des Plasmaraums und der Erdung der Carrier-Rückelektrode.

## Patentansprüche

1. Vorrichtung zum Bewegen eines Carriers (11) in einer Vakuumkammer ( 1 ), wobei dieser Carrier (11) plattenförmig ausgebildet und mittels Antriebsrollen (12, 24) bewegbar ist und wobei die Antriebsrollen (12, 24) mittels eines Hubmechanismus (30, 31) auf eine Schmalseite des plattenförmig ausgebildeten Carriers (11) hin und von diesem weg bewegbar sind, wobei die Antriebsrollen (12, 24) außerdem mit einer Magnetkupplung (74) gekoppelt sind, deren einer Teil (19) innerhalb der Vakuumkammer (1) und deren anderer Teil (20) außerhalb der Vakuumkammer (1) angeordnet ist, wobei eine Buchse (38) in einer Wand (16) der Vakuumkammer (1) vorgesehen ist, welche den anderen Teil (20) der Magnetkupplung (74) aufnimmt, und eine nicht magnetische oder nicht magnetisierbare Membran (37) in die Buchse (38) eingepasst oder Teil der Buchse (38) ist, welche das innere der Vakuumkammer (1) von Atmosphäre und damit den einen Teil (19) der Magnetkupplung (74) von dem anderen Teil (20) trennt.

2. Vorrichtung nach Anspruch 1, wobei die Antriebsrollen (12, 24) auf Transportbalken (17) ruhen und der Hubmechanismus (30, 31) mit dem Transportbalken (17) verbunden ist.

3. Vorrichtung nach Anspruch 1, wobei der Carrier (11) wenigstens eine Ausnehmung aufweist.

4. Vorrichtung nach Anspruch 1, wobei der Carrier (11) einen Durchbruch (40) aufweist.

5. Vorrichtung nach Anspruch 1 und Anspruch 4, wobei ein Haken (14) vorgesehen ist, der durch den Durchbruch (40) greifen und den Carrier (11) tragen kann.

6. Vorrichtung nach Anspruch 1 und Anspruch 5, wobei der Carrier (11) einen Bolzen aufweist, an welchen der Haken (14) angreift.

7. Vorrichtung nach Anspruch 5, wobei der Haken (14) senkrecht zur Oberfläche des Carriers (11) bewegbar ist.

8. Vorrichtung nach Anspruch 7, wobei ein Antrieb für die Bewegung des Hakens (14) vorgesehen ist, der sich außerhalb der Vakuumkammer (1) befindet.

9. Vorrichtung nach Anspruch 1, wobei der eine Teil (19) und der andere Teil (20) der Magnetkupplung (74) in einer ersten Position des Carriers (11) symmetrisch einander gegenüberliegen und in einer zweiten Position des Carriers (11) in vertikaler Richtung gegeneinander verschoben sind.

## Claims

1. Apparatus for displacing a carrier (11) inside a vacuum chamber (1), whereby the carrier (11) is plate-shaped and displaceable with the aid of driving rollers (12, 24) and whereby the driving rollers (12, 24) are displaceable towards and away from a narrow side of the plate-shaped carrier (11) with the aid of a lifting mechanism (30, 31), whereby, furthermore, the driving rollers (12, 24) are coupled to a magnetic coupling (74) of which one part (19) is arranged inside of the vacuum chamber (1) and its other part (20) outside of the vacuum chamber (1), whereby a socket (38) is provided in a wall (16) of the vacuum chamber (1), which accommodates the other part (20) of the magnetic coupling (74), and that a non-magnetic or non-magnetisable membrane (37) is fitted in the socket (38) or is part of the socket (38), which separates the interior of the vacuum chamber (1) from atmosphere and thereby separates the one part (19) of the magnetic coupling (74) from the other part (20).

2. Apparatus according to claim 1, whereby the driving rollers (12, 24) rest on a conveyor beam (17) and the lifting mechanism (30, 31) is connected to the conveyor beam (17).

3. Apparatus according to claim 1, whereby the carrier (11) comprises at least one recess.

4. Apparatus according to claim 1, whereby the carrier (11) comprises a breakthrough (40).

5. Apparatus according to claim 1 and claim 4, whereby a hook (14) is provided, which can engage with the breakthrough (40) and support the carrier (11).

6. Apparatus according to claim 1 and claim 5, whereby the carrier (11) comprises a bolt with which the hook (14) engages.

7. Apparatus according to claim 5, whereby the hook (14) is displaceable perpendicular to the surface of the carrier (11).

8. Apparatus according to claim 7, whereby a drive is provided for displacing the hook (14), which is located outside of the vacuum chamber (1).

9. Apparatus according to claim 1, whereby the one part (19) and the other part (20) of the magnetic coupling (74) are symmetrically facing each other in a first position of the carrier (11) and are displaced in vertical direction against each other in a second position of the carrier (11).

## Revendications

1. Dispositif pour le déplacement d'un support (11) dans une chambre à vide (1), dans lequel ce support (11) est réalisé en forme de plaque et peut être déplacé à l'aide de galets d'entraînement (12, 24) et dans lequel les galets d'entraînement (12, 24) peuvent être déplacés à l'aide d'un mécanisme de levage (30, 31) vers un petit côté du support (11) réalisé en forme de plaque et loin de celui-ci, dans lequel les galets d'entraînement (12, 24) sont en outre couplés à un couplage magnétique (74) dont une partie (19) est disposée dans la chambre à vide (1) et l'autre partie (20) est disposée en dehors de la chambre à vide (1), dans lequel une douille (38) est prévue dans une paroi (16) de la chambre à vide (1), laquelle reçoit l'autre partie (20) du couplage magnétique (74), et qu'une membrane (37) non magnétique ou non magnétisable ou est adaptée dans la douille (38) ou fait partie de la douille (38), laquelle membrane sépare l'intérieur de la chambre à vide (1) de l'atmosphère et sépare ainsi une partie (19) du couplage magnétique (74) de l'autre partie (20).

2. Dispositif selon la revendication 1, dans lequel les galets d'entraînement (12, 24) reposent sur une barre de transport (17) et le mécanisme de levage (30, 31) est relié à la barre de transport (17).

3. Dispositif selon la revendication 1, dans lequel le support (11) présente au moins un évidement.

4. Dispositif selon la revendication 1, dans lequel le support (11) présente une perforation (40).

5. Dispositif selon les revendications 1 et 4, dans lequel une pince (14) est prévue, laquelle peut agir par la perforation (40) et porter le support (11).

6. Dispositif selon les revendications 1 et 5, dans lequel le support (11) présente un boulon, sur lequel agit la pince (14).

7. Dispositif selon la revendication 5, dans lequel la pince (14) peut être déplacée perpendiculairement à la surface du support (11).

8. Dispositif selon la revendication 7, dans lequel un entraînement est prévu pour le déplacement de la pince (14), lequel se trouve en dehors de la chambre de vide (1).

9. Dispositif selon la revendication 1, dans lequel la partie (19) et l'autre partie (20) du couplage magnétique (74) se font face de manière symétrique dans une première position du support (11) et sont décalées dans une seconde position du support (11) dans la direction verticale l'une par rapport à l'autre.
